# EUROPEAN PATENT APPLICATION

(11) **EP 0 773 576 A1**
(43) Date of publication of application: **14.05.1997**
(21) Application number: 96118023.9
(22) Date of filing: 11.11.1996
(51) Int. Cl.: H01J 37/30, H01H 37/04, H01J 37/12

(54) **Electron column optics for multibeam electron lithography system**

(30) Priority: 13.11.1995 US 554995
(71) Applicant: MOTOROLA, INC., Schaumburg, IL 60196 (US)
(72) Inventor: Parker, N. William, Fairfield, California 94533 (US)
(74) Representative: Hudson, Peter David

(57) **Abstract**

Electron column optics include a first electrical lens assembly (13) positioned to receive electrons from a rectangular electron source (12) and designed to accelerate the electrons to a first range of acceleration. The first electrical lens assembly (13) is further designed to substantially compensate for astigmatism produced by the first acceleration. A second electrical lens assembly (14) is positioned to receive electrons from the first electrical lens assembly (13) and is designed to accelerate the electrons to a second range of acceleration. The second electrical lens assembly (14) is further designed to focus the received electrons onto a remote surface (15).

## Description

### Field of the Invention

The present invention pertains to apparatus and a process for imaging an electron source on a remote surface. The present invention is especially useful in electron beam lithographic systems.

### Background of the Invention

One of the major uses of lithographic systems is in the semiconductor art for manufacturing integrated circuits and the like. Generally, complete semiconductor wafers are processed by forming a large number of similar integrated circuits (semiconductor chips) on the wafer and then cutting the wafer into individual chips. Integrated circuits can be patterned on the wafer in a variety of different ways including optical lithography, X-ray lithography, direct-write electron beam lithography, etc. Optical lithography utilizes masks and reticles which are limited in the minimum feature size that can be achieved and have the additional drawback that each subsequent mask or reticle in the set must be accurately registered with the preceding patterned layer. Also, mask generation, inspection and repair adds substantial cost and time delays, since each step must be done with separate and expensive machinery.

In lithography, the wafer is coated with a photosensitive emulsion and a beam of light (or other energetic particles) passes through the mask or reticle and then exposes the components, circuits, interconnecting lines, etc. in the photosensitive emulsion on the wafer. In the past, for example, it has been found that an X-ray beam can be used to expose lines less than one micron wide. The problem is that it takes a great amount of time to expose all of the features in a plurality of chips with a single X-ray beam. Further, as the size of the wafers increases from 100 mm diameter to as much as 300 mm diameter this problem becomes much greater.

Some multibeam electron lithography systems have been devised but these systems are limited in the size of the wafer which can be written, i.e., because of the means for generating the beam and the focusing utilized, the area that can be exposed simultaneously is limited. Generally only a single type of pattern can be written on the wafer because all of the beams are controlled simultaneously, although the single type of pattern can be written on a number of integrated circuits simultaneously. Also, in many instances it is necessary to provide a different system for each size of the wafer being processed. Further, because of the beam generating means and the focusing elements, the spot size and registration accuracy are limited so that the ultimate resolution is only marginally better than can be produced with other methods.

An electron source for use in a multibeam electron lithography system is disclosed in a copending application entitled "Electron Source for Multibeam Electron Lithography System", bearing applicant's docket number CR95-125, mailed to the U.S. Patent Office on August 8, 1995 and assigned to the same assignee. Because of the size and shape of the multiple beams generated in this novel electron source, imaging the electron source on a remote surface, such as a semiconductor wafer, is extremely difficult.

It would be highly advantageous to provide electron column optics for use in multibeam electron lithography systems and the like which is capable of imaging an electron source, such as the one described above, on a remote surface.

Accordingly, it is an object of the present invention to provide new and improved electron column optics.

It is yet another object of the present invention to provide new and improved electron column optics which can conveniently be used in multibeam electron lithography systems to render these systems much more accurate and versatile.

It is yet another object of the present invention to provide new and improved electron column optics which can be utilized in conjunction with multibeam electron sources on substantially any wafer size and which can be used in an electron beam lithography system to write a variety of different integrated circuit patterns on a single wafer, simultaneously.

It is a further object of the present invention to provide a new and improved method of imaging multibeam electron sources on a remote surface.

It is a still further object of the present invention to provide new and improved electron column optics capable of reducing astigmatism and magnifying the image of an electron source to provide substantially square pixels on the remote surface.

### Summary of the Invention

The above problems and others are substantially solved and the above objects and others are realized in electron column optics for imaging an electron source on a remote surface, the optics including a first electrical lens assembly positioned to receive electrons from an electron source and designed to accelerate the electrons to a first range of acceleration, the first electrical lens assembly being further designed to substantially compensate for astigmatism produced by the first acceleration, and a second electrical lens assembly positioned to receive electrons from the first electrical lens assembly and designed to accelerate the electrons to a second range of acceleration, in conjunction with a remote surface, the second electrical lens assembly being further designed to focus the received electrons onto the remote surface.

The above problems and others are substantially solved and the above objects and others are further realized in a method of imaging an electron source on a remote surface, including the steps of providing an electron source including a plurality of pixels for producing a plurality of electron beams, the plurality of pixels generally defining a short axis perpendicular to the optical axis and a long axis, longer than the short axis, perpendicular to the optical axis, defining an optical axis with an electron source positioned at one end and a remote electron receiving surface positioned at an other end, accelerating electrons from the electron source to a first range of acceleration and compensating for astigmatism produced by the first acceleration, and accelerating electrons in the first range of acceleration to a second range of acceleration and focusing the received electrons onto the remote surface.

### Brief Description of the Drawings

Referring to the drawings:
FIG. 1 is a simplified sectional view of electron column optics in accordance with the present invention;
FIG. 2 is an enlarged top plan view of an electron source from the electron column optics illustrated in FIG. 1;
FIG. 3 is a greatly enlarged view in perspective, portions thereof broken away and shown in section, of a two dimensional array of electron emitters;
FIG. 4 is an enlarged view in perspective, portions thereof broken away and shown in section, of a first lens assembly from the electron column optics illustrated in FIG. 1;
FIG. 5 is a sectional view, in a plane containing the optical axis, of the structure illustrated in FIG. 4 illustrating typical sizes and dimensions;
FIG. 6 is an enlarged schematic view of the structure illustrated in FIG. 4, illustrating equipotential lines of electrical potential and electron beams from an electron source;
FIG. 7 is an enlarged view in perspective, portions thereof broken away and shown in section, of a second lens assembly from the electron column optics illustrated in FIG. 1;
FIG. 8 is a sectional view, in a plane containing the optical axis, of the structure illustrated in FIG. 7 illustrating typical sizes and dimensions;
FIG. 9 is a greatly enlarged sectional view, in a plane containing the optical axis, of a portion of the structure illustrated in FIG. 7 illustrating typical sizes and dimensions; and
FIG. 10 is an enlarged schematic view of a portion of the structure illustrated in FIG. 9, illustrating equipotential lines of electrical potential and electron beams from an electron source.

### Description of the Preferred Embodiments

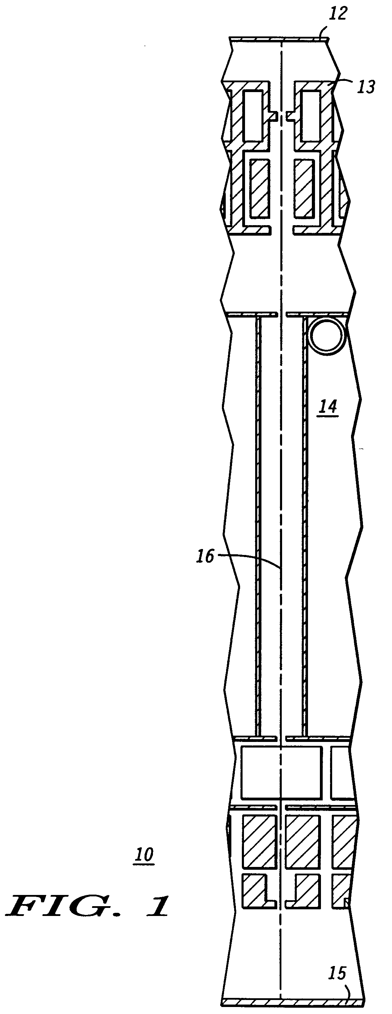

Turning now to the drawings in which like components are designated with like numerals, FIG. 1 illustrates, in a simplified sectional view, electron column optics 10 in accordance with the present invention. Optics 10 includes an electron source 12, a first electrical lens assembly 13, a second electrical lens assembly 14, and a remote surface 15. The various components of electron column optics 10 are arranged to define an optical axis 16, with electron source 12 positioned at one end, remote surface 15 positioned at the other end, and first and second electrical lens assemblies 13 and 14 positioned between electron source 12 and remote surface 15 along optical axis 16.

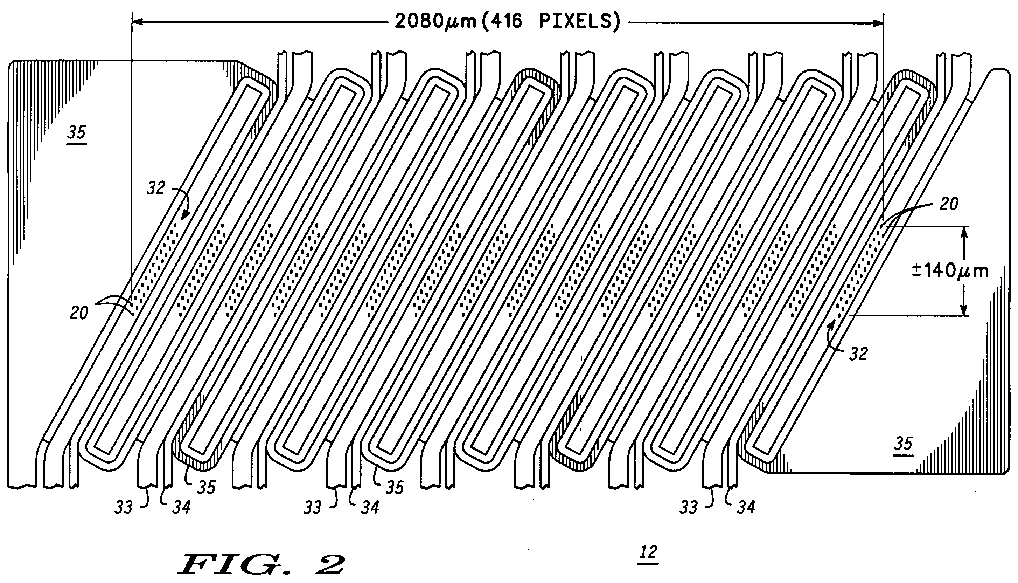

Now referring specifically to FIG. 2, an enlarged top plan view of electron source 12 is illustrated. A more complete description of electron source 12 is contained in the above identified copending U.S. Patent Application, which description is included herein by reference. Electron source 12 includes a non-orthogonal row-column matrix of two dimensional arrays 20 of electron emitters. Each array 20 operates as a single pixel illuminator with each illuminator exposing a separate pixel on a portion of remote surface 15 on which illuminating source 12 is focused. It should be understood that arrays of electron emitters, and specifically field emission emitters, are utilized herein as illuminators for convenience of explanation, but other pixel illuminators could be substituted if desired.

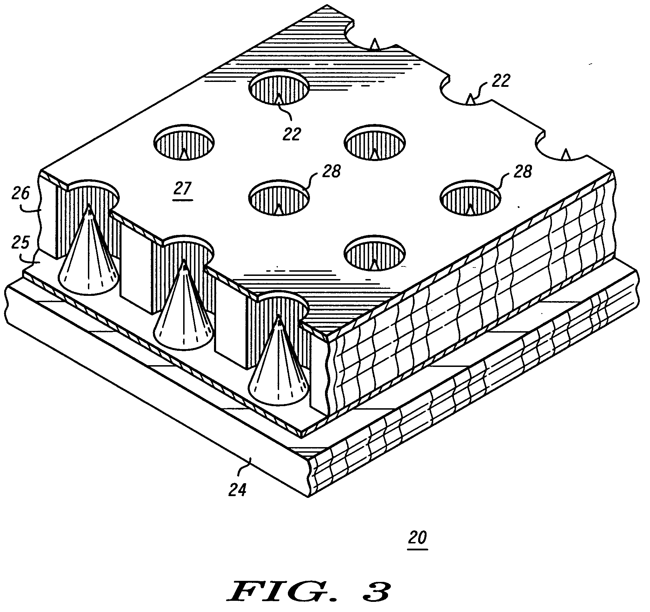

Referring specifically to FIG. 3, a two dimensional array 20 of electron emitters 22 is illustrated in a perspective view, with portions thereof broken away and shown in section for convenience of understanding. In this specific embodiment, array 20 is formed on an insulating substrate 24 that has a layer 25 of conducting material formed thereon, which layer 25 serves as the emitter base. An insulating layer 26 is formed on layer 25 and a second conducting layer 27 is formed on the surface of insulating layer 26. A plurality of spaced apart tubular openings 28 is formed through layers 27 and 26 so as to extend down to and expose the surface of conducting layer 25. An electron emitter 22 is formed on conducting layer 25 in each opening 28.

Generally, array 20, as described, can be fabricated by any convenient means, such as that described in U.S. Patent No. 5,007,873, entitled "Non-Planar Field Emission Device Having an Emitter Formed With a Substantially Normal Vapor Deposition Process", issued April 16, 1991 and included herein by reference. Also, while conical field emission tips generally referred to in the industry as "Spindt tips" are utilized in this specific embodiment, it should be understood that many other types of field emission devices and electron emitters, e.g. diamond and other low work function material type emitters, can be utilized, as will be understood from the following explanation.

As is understood in the field emission art, second conducting layer 27 serves as an extraction or control electrode for array 20. Generally, the tips of electron emitters 22 are located approximately in the plane of second conducting layer 27, with second conducting layer 27 spaced an equidistance from and peripherally surrounding each tip. Since all of electron emitters 22 are formed on and in contact with common conducting layer 25 and a single second conducting layer 27 forms a common control electrode for each electron emitter 22 in array 20, all electron emitters 22 in array 20 are connected in parallel and are activated or inactivated simultaneously.

When a suitable potential is applied between conducting layer 25 and second conducting layer 27, a very high electric field is created around each of the tips which causes each of the tips to emit electrons by field emission. Generally, since all of the electron emitters 22 in an array 20 cooperate to produce a single beam of electrons, an array is considered as a pixel. Also, since all of the electron emitters operate in parallel, the amount of current that must be produced by a single electron emitter 22 is substantially reduced (generally to below a microampere) and there is a certain amount of redundancy.

Generally, it has been found that adequate emission is produced when a potential is applied to conducting layer 27 (the control electrode) that is in a range of 40 volts to 100 volts more positive than electron emitters 22. Also, when electron emitters which are formed of low work function material, such as diamond, are utilized, this potential may drop to as low as 2 to 5 volts. For convenience of explanation and throughout this discussion a potential on conducting layer 27 (the control electrode) that is 100 volts more positive than the potential on conduction layer 25 is assumed to ensure proper operation. In addition, for convenience of explanation, the bias potential on the electron emitters 22 is assumed to be approximately -6000 volts when they are activated and approximately -5900 volts when they are inactivated.

Referring again to FIG. 2, arrays 20 within the row-column matrix are arranged in a plurality of column groups 32 of arrays. In this specific embodiment, a total of sixteen column groups 32 each contain twenty six separate arrays 20 of electron emitters. All sixteen column groups 32 are mounted in a common plane and may be, for example, all positioned on a common supporting substrate 24 (see FIG. 3).

In FIG. 2, each column group 32 has a common elongated control or extractor electrode 33 (similar to conducting layer 27 in FIG. 3) with alternate extractor electrodes 33 extending vertically downward and upward, for connection to an external voltage source (not shown). Each extractor electrode 33 has a separate elongated, generally U-shaped field compensating electrode 34 positioned adjacent thereto, with the plurality of field compensating electrodes 34 being positioned in a common plane with extractor electrodes 33. As will be understood from the previous explanation of conducting layer 27 in conjunction with FIG. 3, the plane containing extractor electrodes 33 and field compensating electrodes 34 is spaced from the emitter base (conducting layer 25) by the thickness of the insulating layer 26. A single surrounding electrode 35 is positioned in the common plane with extractor electrodes 33 and field compensating electrodes 34 so that portions of surrounding electrode 35 extend between adjacent field compensating electrodes. In FIG. 2, surrounding electrode 35 completes each end of electron source 12 and is entwined between adjacent field compensating electrodes 34 in a continuous serpentine fashion.

As will be explained in more detail presently, each of the column groups 32 of arrays 20 are positioned along an axis (generally referred to as the row axis) extending horizontally, or in the X direction, in FIG. 2 and are spaced from adjacent column groups 32. Further, each of the column groups 32 are arranged with the arrays 20 in each column group 32 spaced apart along a column axis, at an angle to the row axis, so that the arrays 20 are evenly spaced when projected into the row axis direction. Thus, while the vertical position of each array 20 varies by a maximum of± half the length of a column group 32 (± 140 µm in this embodiment), all of the arrays 20 are equally spaced along the horizontal row axis.

It should be understood that electron source 12 is utilized for purposes of this explanation only and many other electron sources could be utilized, including any of the additional embodiments disclosed in the above described copending U.S. Patent Application, all of which are included herein by reference.

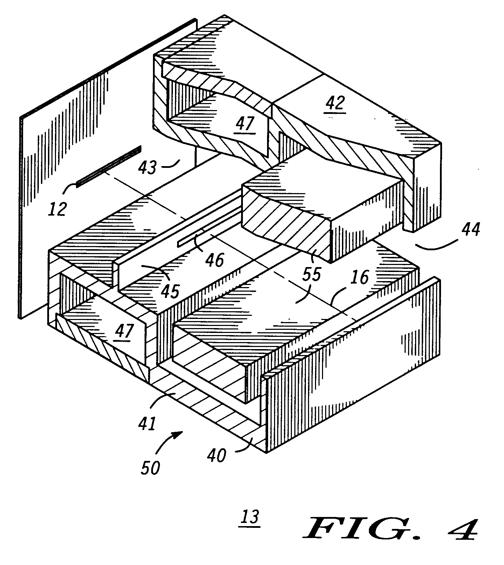

Illustrated in FIG. 4 is an enlarged view in perspective, portions thereof broken away and shown in section, of first lens assembly 13 from electron column optics 10. Electron source 12 is illustrated in FIG. 4 as a flat rectangle, since that is essentially how electron source 12 will appear to lens assembly 13. Generally, a purpose of electron column optics 10 is to magnify electron source 12 by less than one in the X-direction (the long axis of rectangular source 12) and by less than one in the Y-direction (the short axis of rectangular source 12). In this embodiment, electron source 12 is magnified by 0.050 in the X-direction and by 0.025 in the Y-direction. As will be understood presently, this magnification is a result of the present novel configuration and, therefore, each pixel, or array 20, in electron source 12 is fabricated twice as high (Y-direction) as it is wide (X-direction) to produce a square image at remote surface 15. It should be understood that these dimensions and magnifications are only for this specific embodiment and may vary for different embodiments or applications, and for different sources.

Another purpose of lens assembly 13 is to accelerate the electron beam which, in this embodiment, is accelerated from an initial energy of 100eV up to 6000eV. Still another purpose of lens assembly 13 is to transport rays, or electrons, from electron source 12 to second lens assembly 14 with the same virtual or apparent position in both the short axis (Y-direction) and the long axis (X-direction) of electron source 12. That is, electron source 12 should appear to lie in an X-Y plane, in this embodiment slightly behind the actual electron source 12. Also, lens assembly 13 is constructed to intercept a maximum amount of the electron beams from electron source 12 which are directed at too large an angle to optical axis 16 in order to minimize heating of second lens assembly 14. As will be explained presently, all rays from electron source 12 needed to illuminate apertures in second lens assembly 14 must be transmitted through lens assembly 13.

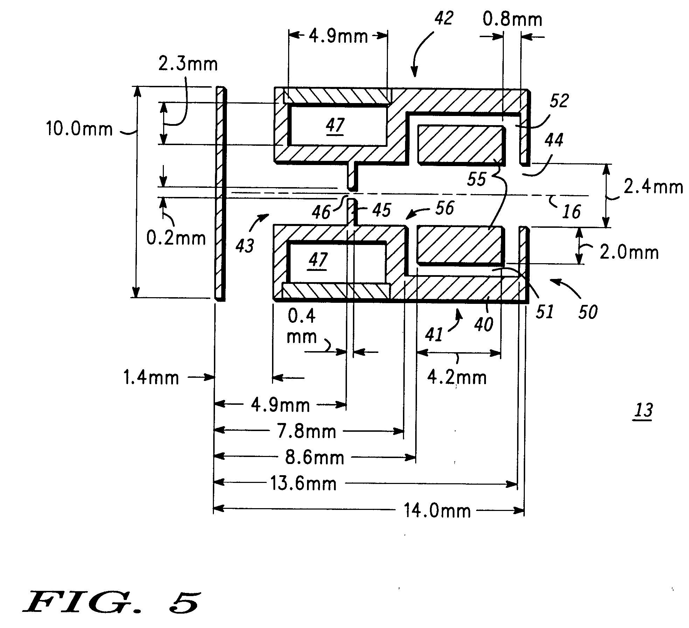

Referring to FIGS. 4 and 5, it can be seen that lens assembly 13 includes a housing 40 with a lower component 41 and an upper component 42, which are mirror images of each other. Components 41 and 42 define therebetween a rectangularly shaped optical channel extending along optical axis 16 with an inlet end 43 and an outlet end 44. Components 41 and 42 are joined by a wall 45, extending perpendicular to the optical channel and optical axis 16, which is spaced from inlet end 43 for reasons that will be explained presently. A generally rectangularly shaped slit aperture 46 is formed in wall 45 with a short dimension extending parallel with the short axis (X-direction) of electron source 12 and a long dimension extending parallel with the long axis (Y-direction) of electron source 12. Because wall 45 intercepts relatively large amounts of rays from electron source 12, water cooling conduits 47 are formed in lower and upper components 41 and 42 of housing 40.

A doublet lens 50 is formed in housing 40, in a position along optical axis 16 to receive electrons from slit aperture 46. To form doublet lens 50, housing 40 is constructed with rectangularly shaped, mirror image channels 51 and 52, positioned on opposite sides of the optical channel and extending perpendicular to the optical channel and optical axis 16. A pair of electrodes 55 are positioned in channels 51 and 52, one each, so as to be spaced from housing 40 and to be positioned on opposite sides of the optical channel. An inlet 56 is defined by housing 40 at one side of mirror image channels 51 and 52 and an outlet, coextensive with outlet end 44 of the optical channel, is defined by housing 40 at the other side.

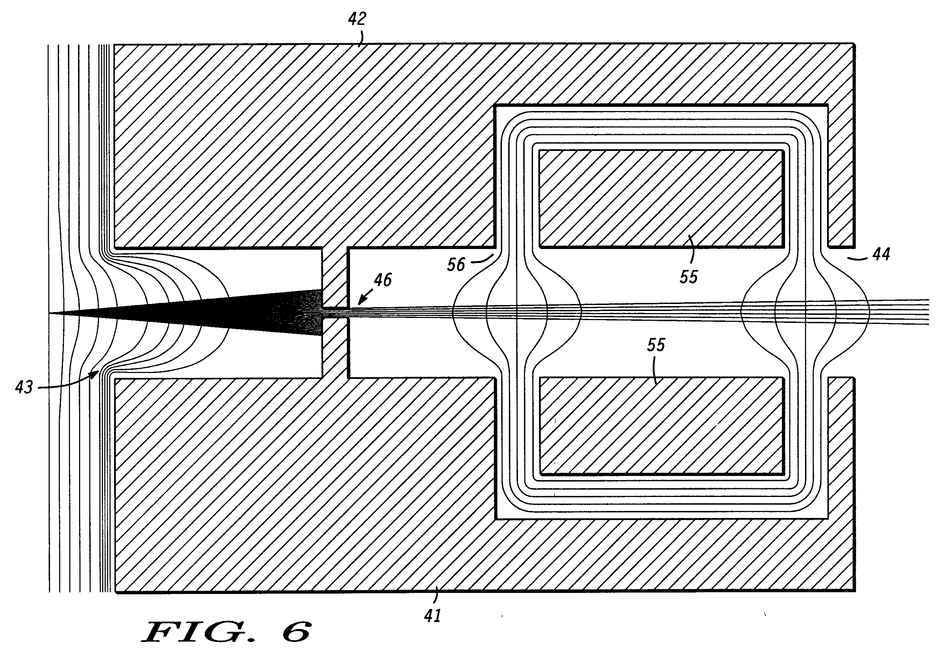

In this specific embodiment, housing 40 has an electrical potential of approximately zero ( e.g. ground) applied thereto and electrodes 5 have an electrical potential in the range of approximately 1100 volts to 1200 volts applied thereto. Referring specifically to FIG. 6, equipotential lines of electrical potential and electron beams from electron source 12 are illustrated schematically in lens assembly 13. Because electron source 12 is operating at approximately -6000 volts and 100 volts are used to emit the electrons, electrons leave electron source 12 at a potential of approximately -5900 volts and an initial energy of approximately 100eV. The equipotential lines adjacent inlet end 43 of the optical channel represent the acceleration of the electrons from approximately 100eV up to approximately 6000eV.

The bending of the equipotential lines into the optical channel at inlet end 43 produces a lens effect which, because the long axis of the optical channel is perpendicular to the paper in FIG. 6, is a cylindrical lens effect (i.e. it operates similar to a cylindrically shaped light-optical lens). The lens effect at inlet end 43 focuses the beam in only the Y-Z plane, where the Z-axis is colinear with the optical axis 16, and has no first-order optical properties in the orthogonal plane (the X-Z plane). In the X-Z plane, as the rays bend toward the Z-axis due to the acceleration of the electrons from 100eV to 6000eV, their back-extrapolated intersection with optical axis 16 (which defines the apparent position of the source) is moved back behind the plane of electron source 12.

The optics of the Y-Z plane is more complicated than for the X-Z plane, since both the angular demagnification due to the beam acceleration and the angular magnification from a diverging slit lens effect must be considered. The slit lens at inlet end 43 is necessarily always diverging (i.e. magnifying angles) due to the bulging of the equipotential lines into the slit region at inlet end 43, which inevitably creates a combination beam acceleration and diverging lens effect, simultaneously. Rays in the Y-Z plane when initially leaving electron source 12 "feel" essentially the same acceleration as do rays in the X-Z plane. As these rays near inlet end 43 of housing 40, however, their decrease in slope with increasing axial velocity is reduced by the diverging lens effect. The back-extrapolated intersection of these rays with the Z-axis results in a virtual source that appears to be in front of the actual electron source 12. This separation of the virtual sources in the X-Z and Y-Z planes results in a large degree of astigmatism, which is unacceptable.

In this specific embodiment, the electron column is constrained to be no larger than 10mm by 10mm in the X-Y plane. The length of lens assembly 13 in the Y-direction is limited by this constraint, thus the slit spacing is made small enough (2.4mm) to minimize fringing field effects at the beam, the relevant portion of which occupies the central±1mm of the column. No rays outside of this±1mm range will pass through second lens assembly 14, thus their aberrations are not significant to the performance of the optics. The 3mm width of slit aperture 46 is chosen to ensure that the rays from the outer edges of electron source 12 pass well away from the edge of slit aperture 46, thus avoiding any field perturbations. The 0.2mm height (Y-direction) of slit aperture 46 is sufficient to pass rays from the±150µm upper and lower edges of electron source 12, since when they reach slit aperture 46 their Y-axis positions have already been reduced by approximately 0.5x from their initial values (the beam width is approximately±0.075µm at slit aperture 46). This ensures that the maximum possible amount of beam current is stopped in lens assembly 13, while still transmitting all rays needed to illuminate second lens assembly 14, as illustrated in FIG. 6.

To remedy the excessive astigmatism produced by the single slit lens (inlet side 43 and slit aperture 46), doublet lens 50 is provided. The optical effect of doublet lens 50 can be seen in FIG. 6. As the electron beam approaches inlet 56, the first accelerating gap, a focusing or converging effect is produced by the bulging equipotential lines, followed by a weaker defocusing or diverging effect as the beam moves into the gap between electrodes 55. Then, as the beam approaches the second or decelerating gap, a defocusing effect is present, followed by a stronger focusing effect as the beam emerges from outlet end 44. Doublet lens 50 actually has a quadruplet combination effect on the beam, with a net total focusing lens effect. Slight changes in the energy of electrons have a slight effect on the virtual source position in doublet lens 50 but this slight chromatic aberration does not have a significant effect on the final spot resolution at remote surface 15.

Thus, the first slit lens (inlet 43 and slit aperture 46) provide the entire beam acceleration from 100eV to 6000eV, while doublet lens 50 is an accelerating "einzel" type in which the beam is first accelerated and then decelerated as it passes by electrodes 55, exiting with the same energy with which it entered. All einzel lenses have a net converging effect, regardless of whether their center electrode is + or - relative to the outer electrodes. In this case it was found to be preferable to operate lens 50 in the acceleration mode, in which electrodes 55 have a positive voltage applied thereto relative to housing 40.

In lens assembly 13, there are three factors affecting the ray slopes in the Y-Z plane: the converging effect of the beam acceleration from electron source 12 into the first slit lens; the diverging effect of the first slit lens; and the converging effect of doublet lens 50. With proper selection of the bias voltage on electrodes 55, it was found that the back-extrapolated rays can be made to emanate from a virtual source approximately in the same plane for the X-Z and Y-Z planes. The astigmatism from the first slit lens is thus corrected by the addition of doublet lens 50. Also, angular magnification in the Y-Z plane is 2x the angular magnification in the X-Z plane and source magnification in the Y-Z plane is 0.5x the source magnification in the X-Z plane.

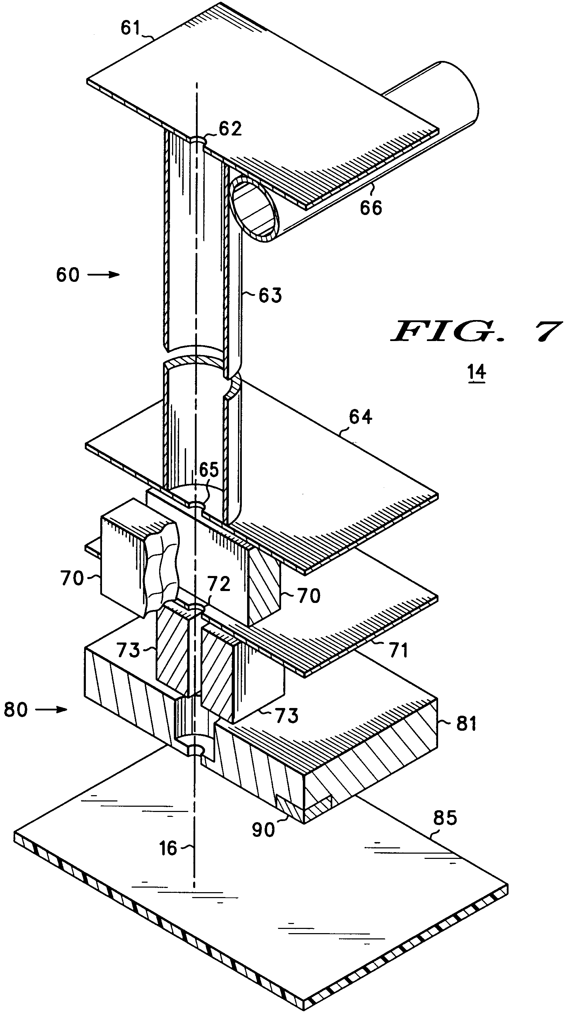

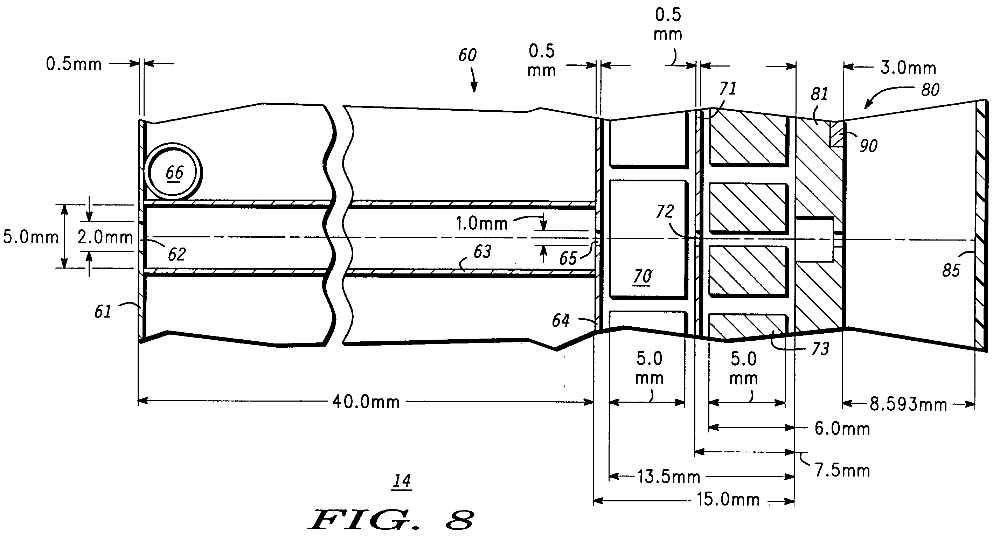

Second lens assembly 14 is illustrated in FIGS. 7 and 8. Assembly 14 includes a beam tube structure 60 with a first plate 61 positioned perpendicular to optical axis 16 and containing a centrally located first aperture 62, a beam tube 63 concentrically surrounding optical axis 16 and a second plate 64 having a centrally located aperture 65. A cooling conduit 66 is affixed to structure 60 because some electrons will still strike plate 61, causing some heat to be generated. Assembly 14 is positioned coaxial with optical axis 16 so as to receive electrons from outlet 44 of first lens assembly 13.

A first pair of Y-axis deflecting plates 70 are positioned on either side of optical axis 16 and spaced from aperture 65 of structure 60 so as to provide deflection of the beams in the Y-axis when properly activated. A plate 71, having a centrally located aperture 72, is positioned adjacent the outlet of Y-axis deflecting plates 70 to restrict any wayward electrons from continuing along optical axis 16. A second pair of X-axis deflecting plates 73 are positioned on either side of optical axis 16 and spaced from aperture 72 of plate 71 so as to provide deflection of the beams in the X-axis when properly activated. It should be noted that all of the apertures 62, 65, and 72 are substantially round and that plates 61, 64, and 71 are all at a substantially zero potential so that normal deflection optics (no lensing effect) apply.

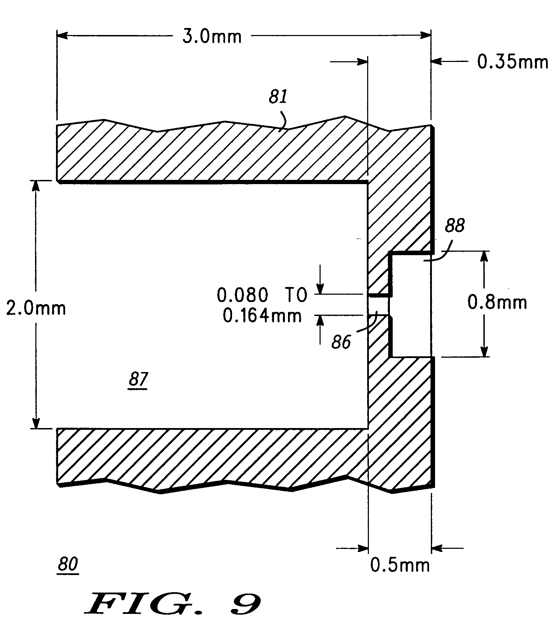

Second lens assembly 14 also includes a final focusing lens 80 formed in a plate 81, which is positioned perpendicular to optical axis 16 and between deflecting plates 73 and a surface 85 positioned to have electron source 12 imaged thereon. Focusing lens 80, which can best be seen in FIG. 9, includes a final aperture 86 having associated therewith an inlet opening 87 and an outlet opening 88. Aperture 86 and openings 87 and 88 are all substantially round and opening 88 has a larger diameter than aperture 86 while opening 87 has a larger diameter than opening 88. For example, in the present embodiment aperture 86 has a diameter in the range of approximately 0.080 to 0.164mm, opening 87 has a diameter approximately 2.0mm and opening 88 has a diameter approximately 0.8mm. Also, while different types of openings 87 and 88 will provide the desired results, in this embodiment openings 87 and 88 are both counterbores formed in plate 81 from opposite sides and all of aperture 86 and openings 87 and 88 are formed coaxial with each other and with optical axis 16.

A back-scattered electron detector is provided in a surface of plate 81 directed toward surface 85. When an electron beam is provided from electron source 12, electrons striking surface 85 will produce some back-scattered electrons. By detecting this back-scattered current, information on the surface 85 can be provided, such as the position of alignment marks. Detector 90 can be a solid-state diode detector mounted in plate 81 and electrically attached to an external circuit which is capable of providing the necessary detector bias voltage and also of collecting the detector signal current.

A purpose of lens assembly 14 is to form a focused image of each active pixel in electron source 12 onto surface 85 with both on and off axis optical aberrations minimized to a level consistent with a desired final spot size on surface 85. A further purpose is to provide overall source magnifications of 0.05x in Y-axis direction and 0.025x in the X-axis direction, when combined with the optical effects of lens assembly 13. Also, lens assembly 14 operates as an accelerating immersion electrostatic lens for which surface 85, which has a potential in the range of 60,000 volts to 70,000 volts applied thereto, forms the final electrode.

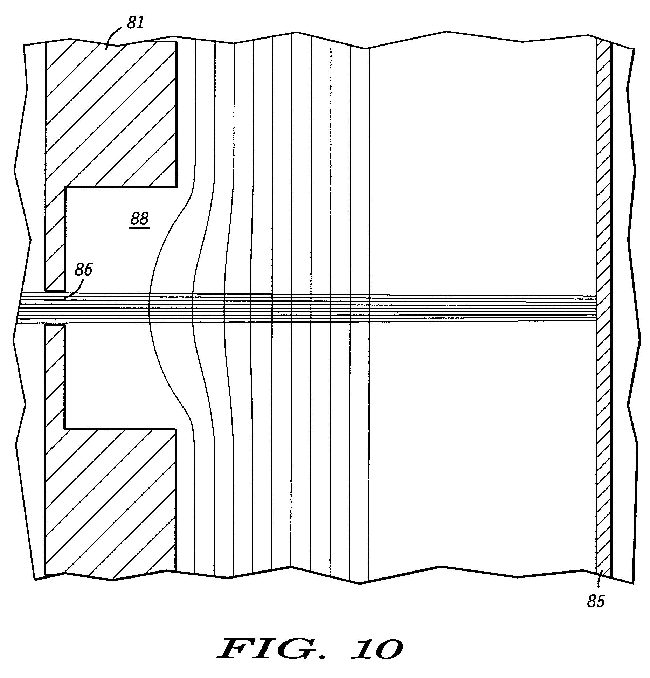

Referring to FIG. 10, a schematic diagram of focusing lens 80, along with equipotential lines of electrical potential and electron beams from electron source 12, are illustrated. It should be noted that the equipotential lines bulge into opening 88. The curved shape of the equipotential lines illustrates the focusing effect of lens 80, since the force acting the electrons of the beam is always perpendicular to the equipotential lines. As can be seen, over the greater part of the distance from focusing lens 80 to surface 85, the beam passes through an essentially smooth and linear field gradient, represented by the straight, equally spaced, equipotential lines shown.

Thus, new and improved electron column optics are disclosed which are capable of imaging an electron source, such as the one described above, on a remote surface. While the novel electron column optics are designed primarily for use in multibeam electron lithography systems and the like, it will be readily understood by those skilled in the art that the novel electron column optics can be utilized many other applications. The new and improved electron column optics can conveniently be used in multibeam electron lithography systems to render these systems much more accurate and versatile. Further, the new and improved electron column optics can be utilized in conjunction with multibeam electron sources on substantially any wafer size and can be used in an electron beam lithography system to write a variety of different integrated circuit patterns on a single wafer, simultaneously. The new and improved electron column optics are capable of reducing astigmatism and magnifying the image of an electron source to provide substantially square pixels on the remote surface, which pixels are extremely accurately imaged on the surface of the wafer or other structure.

While I have shown and described specific embodiments of the present invention, further modifications and improvements will occur to those skilled in the art. I desire it to be understood, therefore, that this invention is not limited to the particular forms shown and I intend in the appended claims to cover all modifications that do not depart from the spirit and scope of this invention.

## Claims

1. Electron column optics (10) for imaging an electron source (12) on a remote surface (15), the optics comprising:
an electron source (12);
a first electrical lens assembly (13) positioned to receive electrons from the electron source (12) and designed to provide a first acceleration of the electrons to a first range of acceleration, the first electrical lens assembly (13) being further designed to substantially compensate for astigmatism produced by the first acceleration; and
a second electrical lens assembly (14) positioned to receive electrons from the first electrical lens assembly (13) in the first range of acceleration and designed to provide a second acceleration of the electrons to a second range of acceleration, in conjunction with a remote surface (15), the second electrical lens assembly (14) being further designed to focus the received electrons onto the remote surface (15).

2. Electron column optics as claimed in claim 1 wherein the electron column optics defines an optical axis (16) with the electron source (12) positioned at one end, the remote surface (15) positioned at the other end and the first (13) and second (14) electrical lens assemblies positioned between the electron source (12) and the remote surface (15) along the optical axis (16).

3. Electron column optics as claimed in claim 2 wherein the electron source (12) includes a plurality of pixels (20) for producing a plurality of electron beams, the plurality of pixels (20) generally define a short axis (y) perpendicular to the optical axis (16) and a long axis (X), longer than the short axis (Y), perpendicular to the optical axis (16).

4. Electron column optics as claimed in claim 3 wherein the first electrical lens assembly (13) includes a generally rectangularly shaped slit aperture (46) extending parallel with the long axis (X) of the source (12).

5. Electron column optics as claimed in claim 4 wherein the generally rectangularly shaped slit aperture (46) has an electrical potential applied thereto that is low relative to a potential of electrons emitted from the electron source (12).

6. Electron column optics as claimed in claim 4 wherein the first electrical lens assembly (13) further includes a doublet lens (50) positioned along the optical axis (16) and defined by an inlet (43) having a first potential applied thereto, a pair of spaced apart electrodes (55) defining a passage extending parallel with the long axis (X) of the electron source (12) and also extending along the optical axis (16), the pair of electrodes (55) having a second potential applied thereto higher than the first potential, and an outlet (44) having the first potential applied thereto, the doublet lens (50) being positioned along the optical axis (16) so as to receive electrons from the slit aperture (46).

7. Electron column optics as claimed in claim 6 wherein the second electrical lens assembly (14) includes structure defining a plurality of spaced apart apertures (62, 65, 72) axially aligned along the optical axis (16).

8. Electron column optics as claimed in claim 1 wherein each pixel (20) of the electron source (12) is formed with a generally rectangular shape, each pixel (20) having a long axis parallel to the short axis (Y) of the electron source (12) and a short axis parallel to the long axis (X) of the electron source (12), and the first and second electrical lens assemblies (13, 14) have a combined magnification such that each pixel (20) imaged on the remote surface (15) is substantially square.

9. Electron column optics as claimed in claim 8 wherein the combined magnification of the first and second electrical lens assemblies (13, 14) is less than one.

10. A method of imaging an electron source on a remote surface, characterized by the steps of:
providing an electron source (12) including a plurality of pixels (20) for producing a plurality of electron beams, the plurality of pixels (20) generally defining a short axis (Y) perpendicular to an optical axis (16) and a long axis (X), longer than the short axis (Y), perpendicular to the optical axis (16);
defining the optical axis (16) with the electron source (12) positioned at one end and a remote electron receiving surface (15) positioned at an other end;
accelerating electrons from the electron source (12) to a first range of acceleration and compensating for astigmatism produced by the first acceleration; and
accelerating electrons in the first range of acceleration to a second range of acceleration and imaging the electron source (12) onto the remote surface (15).
